(19) Europäisches Patentamt
European Patent Office
Office européen des brevets

(11) Publication number: **0 115 156**
**A2**

(12) **EUROPEAN PATENT APPLICATION**

(21) Application number: 83307757.1

(22) Date of filing: 20.12.83

(51) Int. Cl.³: G 03 F 7/02
G 03 F 7/08

(30) Priority: 27.12.82 JP 234651/82

(43) Date of publication of application: 08.08.84 Bulletin 84/32

(84) Designated Contracting States: DE GB

(71) Applicant: FUJI PHOTO FILM CO., LTD.
210 Nakanuma Minamiashigara-shi
Kanagawa-ken(JP)

(72) Inventor: Nagano, Teruo
c/o Fuji Photo Film Co., Ltd. No. 210, Nakanuma
Minami Ashigara-shi Kanagawa(JP)

(72) Inventor: Nagashima, Akira
c/o Fuji Photo Film Co., Ltd. No. 4000, Kawajiri
Yoshida-cho Haibara-gun Shizuoka(JP)

(74) Representative: Blake, John Henry Francis et al,
BROOKES AND MARTIN High Holborn House 52/54 High Holborn
London WC1V 6SE(GB)

(54) **Light sensitive composition.**

(57) The composition includes at least one o-naphthoquinonediazide compound and a color-changing agent, and the o-naphthoquinonediazide compound is represented by the general formula (I):

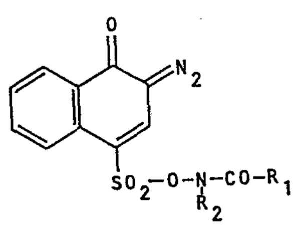

(1)

wherein the substituents for the general formula (I) are defined within the specification. The color forming agent is capable of interacting with a photolysis product of the o-naphthoquinonediazide compound and capable of changing color upon the interaction. The compounds represented by the general formula (I) surprisingly form free radicals when struck by light when presenting the light-sensitive composition. The free radicals effectively and immediately change the color of the copresent color-changing agent which results in the formation of a visibly distinct boundary between exposed and unexposed areas. This visibly distinct boundary makes it easy to work with materials which utilized the composition of the invention by making it possible to distinguish between exposed and unexposed materials as well as exposed portions of individual materials.

EP 0 115 156 A2

# LIGHT-SENSITIVE COMPOSITION

## FIELD OF THE INVENTION

The present invention relates to a light-sensitive composition for producing lithographic printing plates, letterpress printing plates, IC circuits, and photomasks. More particularly, it relates to a light-sensitive composition in which at least one o-naphthoquinonediazide compound is combined with a certain kind of color-changing agent to provide a visible image imediately after imagewise exposure.

## BACKGROUND OF THE INVENTION

Light-sensitive compositions containing o-naphthoquinonediazide-sulfonic acid ester or amide compounds are known and industrially widely used for producing lithographic plates. Particularly the compositions are useful for so-called presensitized plates comprising a support having previously provided thereon the light-sensitive composition (usually called PS plates), letterpress printing plates, IC circuits, photomasks or photoresists for manufacturing printed wiring due to their excellent properties. However, the light-sensitive compositions containing the o-naphthoquinonediazide compounds have the following defect.

That is, a light-sensitive naphthoquinonediazide compound initially appearing yellow becomes, upon exposure, a colorless or slightly yellow photolysis product but, under yellow safe light employed during the exposing procedure, exposed areas and unexposed areas cannot be discriminated from each other after exposure. Therefore, in exposing many plates at the same time, it is impossible to know, when the exposing procedure is interrupted, whether a plate given to a plate-making worker has been exposed or not. Likewise, when exposing a large plate many times as in producing a lithographic printing plate according to a photocomposing process, a worker is unable to confirm which areas have been exposed. This often leads to mistreatment and can seriously deteriorate workability.

In order to remove the defect, several techniques of forming visible images after exposure of a light-sensitive composition have been proposed.

Examples of these proposed techniques include: using various reducible salts in combination with a diazo compound, described in U.S. Patents 2,066,913 and 2,618,555; a technique of obtaining a visible image from a light-sensitive diazo compound and an acid-base indicator, described in Japanese Patent Publication No. 2203/65 corresponding to

British Patent 1,041,463; a composition comprising a light-sensitive positive working diazo resin and a merocyanine dye, described in Japanese Patent Publication No. 3041/74; a technique of incorporating an organic colorant changing in color at pH 2.5 to 6.5 as uniform particles in the light-sensitive layer of a original printing plate previously rendered light-sensitive with o-naphthoquinonediazide, described in Japanese Patent Publication No. 21093/65 corresponding to British Patent 1,039,475; a technique of incorporating, in a light-sensitive copying layer containing o-naphthoquinonediazide-sulfonic acid ester or amide, 10 to 75 wt% of o-naphthoquinonediazide-4-sulfonic acid halogenide based on the total weight of o-naphthoquinonediazide compounds and 1 to 50 wt% of a salt-forming organic compound as a dye, described in Japanese Patent Application (OPI) No. 36209/75 corresponding to U.S. Patent 3,969,118; and a composition containing an ester compound between phenol substituted by an electron acceptive substituent and o-naphthoquinonediazide-4-sulfonic acid and an organic dye which undergoes inter-action with a photolysis product of the o-naphthoquinonediazide compound to change the color tone of the product, described in Japanese Patent Application (OPI) No. 62444/80 (The term "OPI" as used herein means a " published unexamined Japanese patent

application".) corresponding to British Patent 2,038,801.

However, in many cases, visible images obtained by exposing these improved compositions still have insufficient contrast under yellow safe light employed in exposing procedure, and the aforesaid photocomposing work cannot be smoothly conducted without difficulty. In addition, where sufficient contrast is obtained, serious influences on physical properties and developability of light-sensitive layer are usually involved, and sufficient contrast is not be obtained after long periods of storage. Accordingly, under existing circumstances, compositions with satisfactory properties are not available.

## SUMMARY OF THE INVENTION

It is an object of the present invention to provide a light-sensitive composition which provides a highly contrasty visible image by exposure.

Another object of the present invention is to provide a highly sensitive light-sensitive composition which affords a light-sensitive layer having excellent physical properties and developability.

A further object of the present invention is to provide an o-naphthoquinonediazide compound-containing a light-sensitive composition which provides sufficient contrast even after being stored for a long time.

As a result of various investigations, the inventors have found that the above-described objects may be attained by a light-sensitive composition containing at least one o-naphthoquinonediazide compound represented by the following general formula (I):

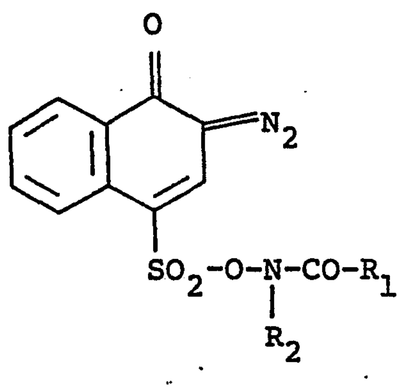

(I)

wherein $R_1$ and $R_2$, which may be the same or different, each represents an alkyl group, a substituted alkyl group, an aryl group, a substituted aryl group, a vinyl group or a substituted vinyl group, or $R_1$ and $R_2$ may be connected to each other to represent an alkylene group

and a color-changing agent which undergoes interaction with a photolysis product of the o-naphthoquinonediazide compound to change its color.

## DETAILED DESCRIPTION OF THE INVENTION

In the above general formula (I), $R_1$ and $R_2$ each independently represents an alkyl group, a sustituted alkyl group, an aryl group, a substituted

aryl group, a vinyl group or a substituted vinyl group. The alkyl group includes straight-chain branched chain and/or cyclic alkyl groups, with those containing about 1 to about 10 carbon atoms being preferable. Specific examples thereof include a methyl group, an ethyl group, a propyl group, a butyl group, a hexyl group, an octyl group, a decyl group, an isopropyl group, an isobutyl group, a tert-butyl group, a 2-ethylhexyl group, a cyclohexyl group, etc. The substituted alkyl group represented by $R_1$ or $R_2$ includes those of the above-described alkyl groups which are substituted by a halogen atom (e.g., a chlorine atom), an alkoxy group containing 1 to 2 carbon atoms (e.g., a methoxy group), an aryl group (e.g., a phenyl group), an aryloxy group (e.g., a phenoxy group), etc. Specific examples thereof include a monochloromethyl group, a dichloromethyl group, a trichloromethyl group, a bromomethyl group, a 2-chloroethyl group, a 2-bromoethyl group, a 2-methoxyethyl group, a 2-ethoxyethyl group, a phenylmethyl group, a naphthylmethyl group, a phenoxymethyl group, etc. The aryl group represented by $R_1$ or $R_2$ is preferably monocyclic or bicyclic and includes, for example, a phenyl group, an α-naphthyl group, a β-naphtyl group, etc. The substituted aryl group represented by $R_1$ or $R_2$ includes those of the above-described aryl groups

which are substituted by an alkyl group containing 1 to 2 carbon atoms (e.g., a methyl group, an ethyl group, etc.), an alkoxy group containing 1 to 2 carbon atoms (e.g., a methoxy group, an ethoxy group, etc.), a halogen atom (e.g., a chlorine atom), a nitro group, a phenyl group, a carboxy group, a cyano group, etc. Specific examples thereof include a 4-chlorophenyl group, a 2-chlorophenyl group, a 4-bromophenyl group, a 4-nitrophenyl group, a 3-nitrophenyl group, a 4-phenylphenyl group, a 4-methylphenyl group, a 2-methylphenyl group, a 4-ethylphenyl group, a 4-methoxyphenyl group, a 2-methoxyphenyl group, a 4-ethoxyphenyl group, a 2-carboxyphenyl group, a 4-cyanophenyl group, a 4-methyl-1-naphthyl group, a 4-chloro-1-naphthyl group, a 5-nitro-1-naphthyl group, a 6-chloro-2-naphthyl group, a 4-bromo-2-naphthyl group, a 5-nitro-2-naphthyl group, etc. The substituted vinyl group represented by $R_1$ or $R_2$ includes vinyl groups substituted by an alkyl group containing 1 to 5 carbon atoms (e.g., a methyl group), an aryl group (e.g., a phenyl group), or the like. Specific examples thereof include a 1-methylvinyl group, a 2-methylvinyl group, a 1,2-dimethylvinyl group, a 2-phenylvinyl group, a 2-(p-methylphenyl)-vinyl group, a 2-(methoxyphenyl)vinyl group, a 2-(p-chlorophenyl)vinyl group, a 2-(o-chlorophenyl)vinyl

group, etc. The alkylene group represented by $R_1$ and $R_2$ connected to each other includes straight-chain, branched-chain and/or cyclic chain, with those containing about 2 to about 10 carbon atoms being preferable. For example, the alkylene group includes an ethylene group, a trimethylene group, a propylene group, an ethylethylene group, a 1,1-dimethylethylene group, a 1-ethyl-1-methylethylene group, a 1,2-dimethylethylene group, a tetramethylethylene group, a 2-methyltrimethylene group, a 2-ethyltrimethylene group, a 2,2-dimethyltrimethylene group, a tetramethylene group, a pentamethylene group, etc.

The o-naphthoquinonediazide compounds used in the present invention and represented by the foregoing general formula (I) can be synthesized by subjecting a compound represented by the following general formula (II):

$$R_1-CO-\underset{\displaystyle R_2}{\underset{|}{N}}-OH \qquad (II)$$

(wherein $R_1$ and $R_2$ are the same as defined with the general formula (I)) obtained by the processes described in, for example, E.E. Smissman et al; Journal of Organic Chemistry, Vol. 37, pp.1847-1849 (1972),

H.E. Baumgarten et al; Journal of Organic Chemistry, Vol. 30, pp.1203-1206 (1965), S.A. Martlin et al; Journal of Chemical Society, Perkin I, pp.2481-2487 (1979), P.G. Mattingly et al; Journal of Organic Chemistry, Vol. 45, pp.410-415 (1980), etc. and 1,2-naphthoquinone-2-diazide-4-sulfonic acid chloride to dehydro-chlorination condensation reaction in the copresence of a dehydrochlorinating agent. This reaction proceeds in either water or an organic solvent as long as a dehydrochlorinating agent coexists. In conducting the reaction in water, lithium hydroxide, sodium hydroxide, potassium hydroxide, sodium carbonate, potassium carbonate, etc. are suitable as the dehydrochlorinating agents. In conducting the reaction in an organic solvent, organic solvents having no hydroxy groups such as diethyl ether, di-isopropyl ether, acetone, dichloromethane, chloroform, carbon tetrachloride, tetrahydrofuran, dioxane, ethyl acetate, benzene, toluene, acetonitrile, etc. are preferable as the organic solvents and, as the dehydrochlorinating agent, pyridine, diethylamine, triethylamine, N,N-dimethylaniline, N,N-diethylaniline, etc. are preferable.

In the reaction, 1 to 1.5 equivalents of 1,2-naphthoquinone-2-diazide-4-sulfonic acid chloride and 1 to 1.5 equivalents of the dehydrochlorinating

agent are preferably used per equivalent of the compound of the general formula (II). Reaction temperature is preferably -10 to 40°C.

Specific example of the o-naphthoquinonediazide compounds to be used in the present invention are those having the structures shown below:

No. 1

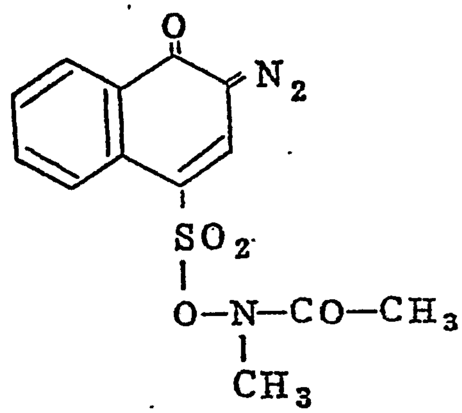

No. 2

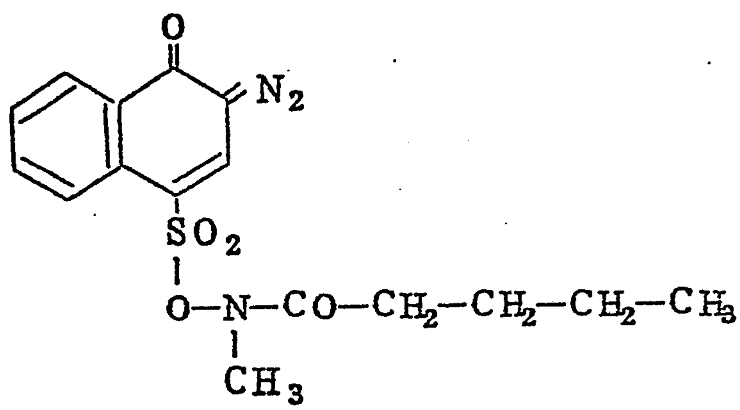

No. 3

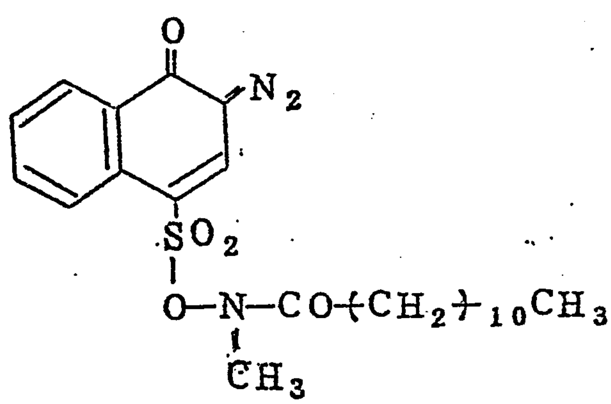

No. 4

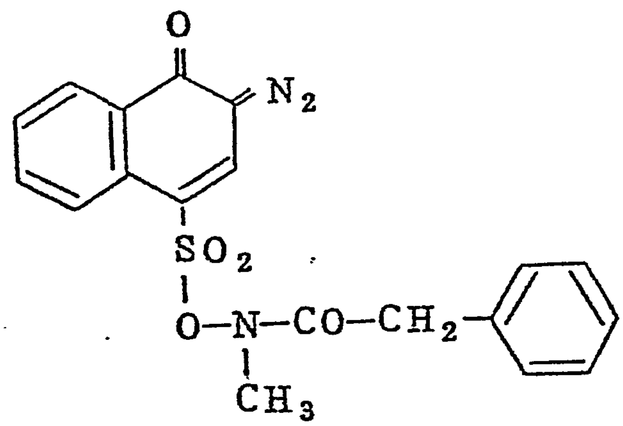

No. 5

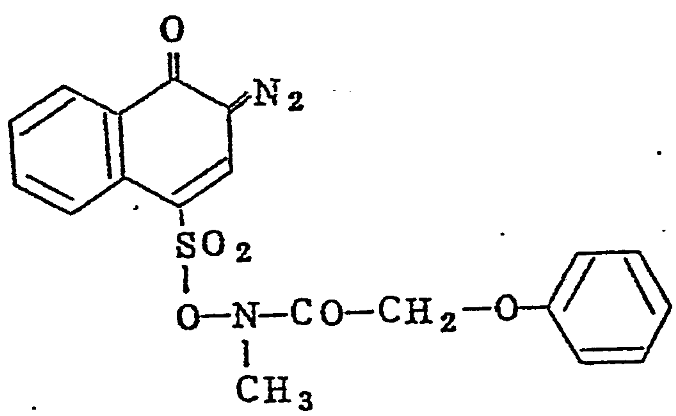

No. 6

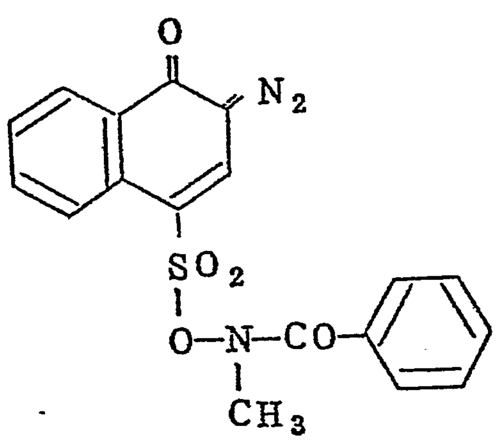

No. 7

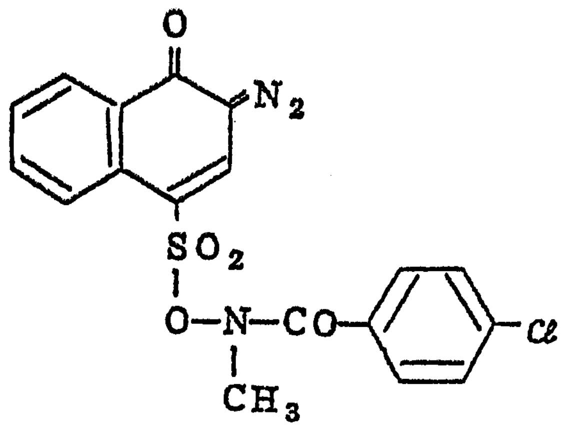

No. 8

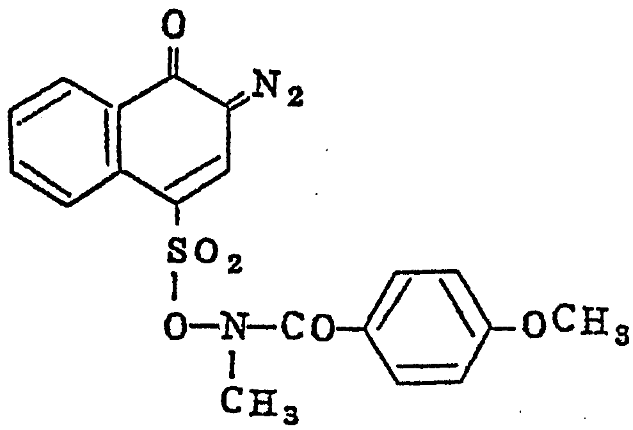

No. 9

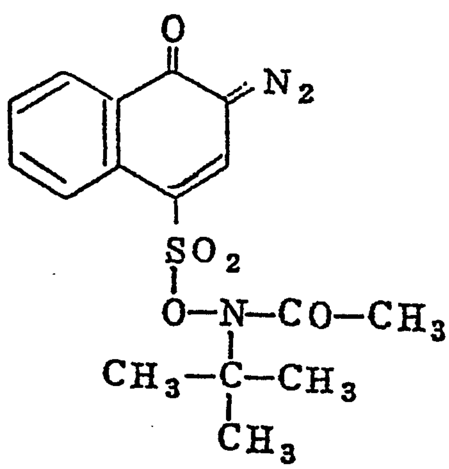

№ 10

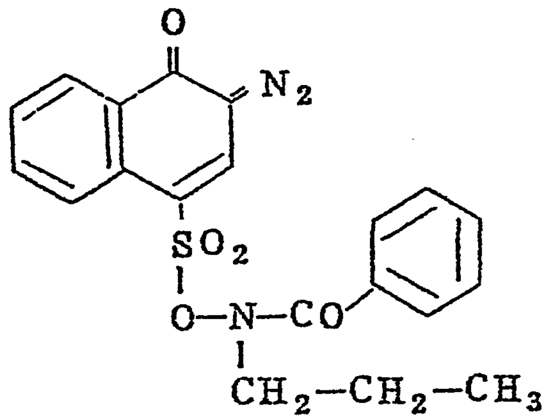

№ 11

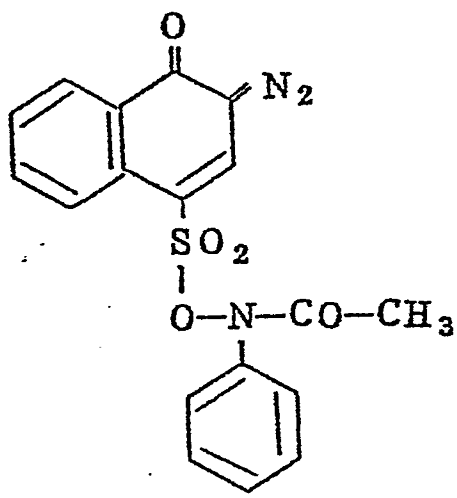

№ 12

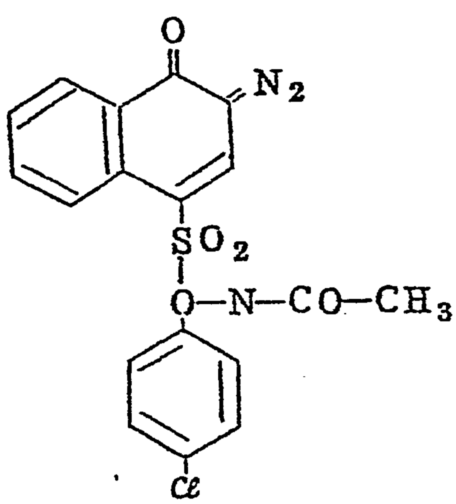

No. 13

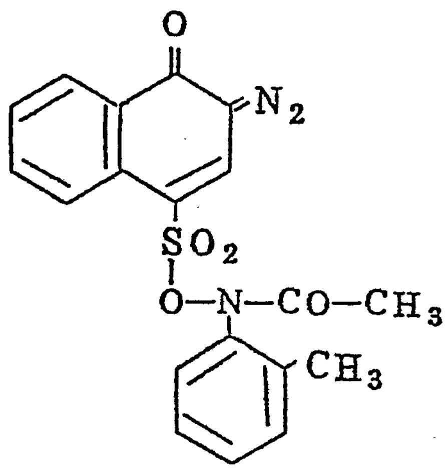

No. 14

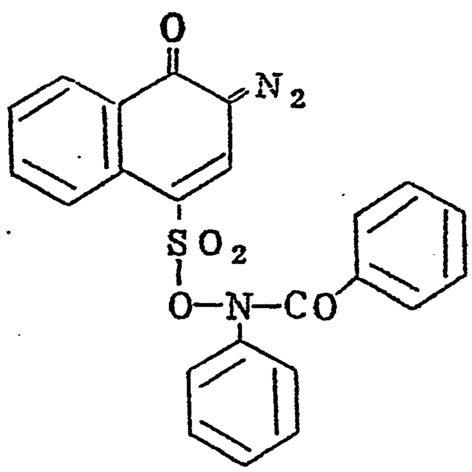

No. 15

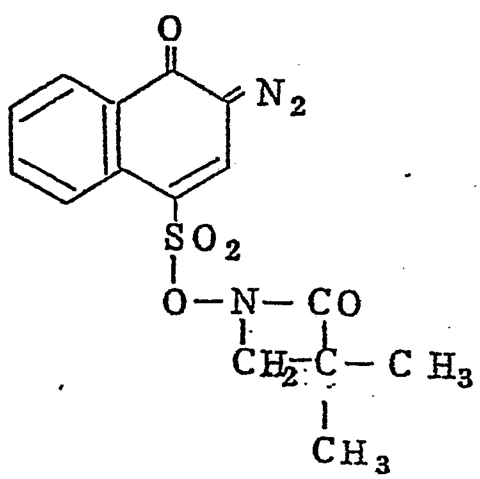

No. 16

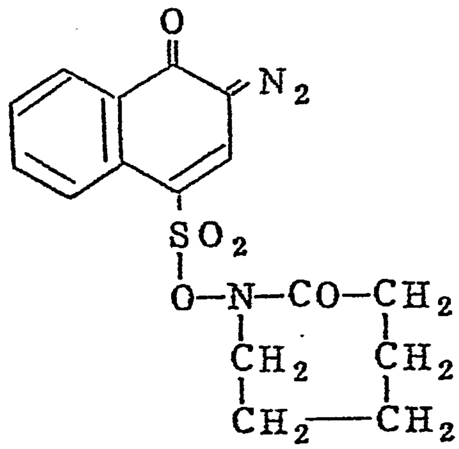

No. 17

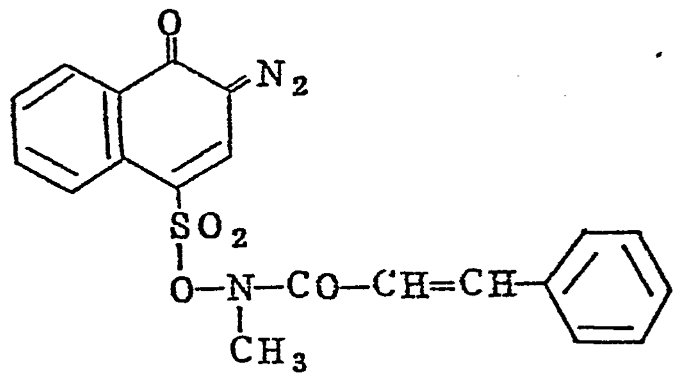

No. 18

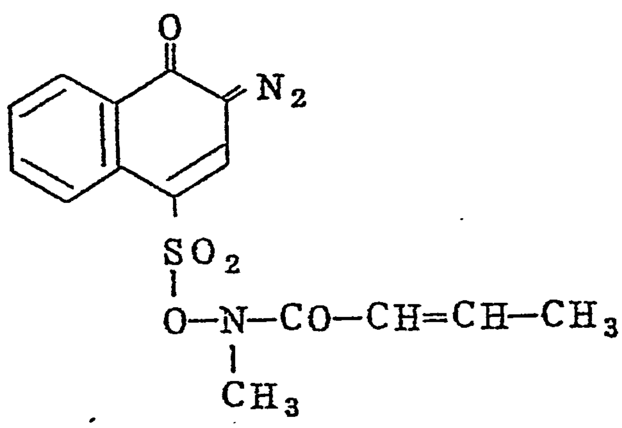

Of the above o-naphthoquinonediazides compounds of Nos. 1,3,6 and 7 are most preferable.

When irradiated with actinic light of about 250 nm to about 500 nm in wavelength, the compounds represented by the general formula (I) produce free radicals with extreme efficiency. Therefore, they can be used in light-sensitive compositions containing an ingredient which, when irradiated with actinic light, produces a free radical (hereinafter referred to as a free radical-producing agent) as a necessary ingredient, such as light-sensitive compositions for preparing light-sensitive elements (e.g., light-sensitive materials for preparing printing plates such as lithographic printing plates, letterpress printing plates, intaglio printing plates, etc., photoresist materials, and the like). In particular, highly sensitive light-sensitive compositions can be obtained by using the compounds represented by the foregoing general formula as free radical-producing agents in light-sensitive compositions which, when only exposed, immediately provide visible contrast between exposed areas and unexposed areas.

The compounds represented by the foregoing general formula (I) in accordance with the present invention are particularly useful when used in a light-sensitive, resist-forming composition for preparing

lithographic printing plates, IC circuits, photomasks, etc. to give the composition such ability that visible contrast is immediately attained between unexposed areas and exposed areas by exposure alone without development (hereinafter referred to as print-out ability).

A light-sensitive, resist-forming composition with such print-out ability can provide a visible image only by exposure which is visible under yellow safe light in exposing procedure. Therefore, when exposing many plates at the same time, the composition makes it possible for plate-making workers to check, in the case of, for example, interrupting the exposing work, whether plates given to the workers have been exposed or not. Likewise, when exposing a large plate many times as in a so-called photocomposing process for making lithographic printing plates, workers can immediately know which portions have been exposed.

A composition to be used for affording such print-out ability (hereinafter referred to as a print-out composition) comprises a free radical-producing agent and a color-changing agent which change in color with a free radical produced from the free radical-producing agent. In the present invention, the compounds represented by the foregoing general formula (I) are used as the free radical-producing agents.

As the color-changing agents that change in color as a result of mutual action with a photolysis product of the o-naphthoquinonediazide compound of the present invention, there are two types: one being those which are initially colorless and, as a result of the mutual action, acquire color; and the other being those which are initially colored and, as a result of the mutual action change color or become colorless.

Typical examples of the color-changing agents of the former type include arylamines. As arylamines suited for the above-described purpose, there are included simple arylamines such as primary and secondary aromatic amines and so-called leuco dyes. Examples thereof are: diphenylamine, dibenzylaniline, triphenylamine, diethylaniline, diphenyl-p-phenylenediamine, p-toluidine, 4,4'-biphenyldiamine, o-chloroaniline, o-bromoaniline, 4-chloro-o-phenylenediamine, o-bromo-N,N-dimethylaniline, 1,2,3-triphenylguanidine, naphthylamine, diaminodiphenylmethane, aniline, 2,5-dichloroaniline, N-methyldiphenylamine, o-toluidine, p,p'-tetramethyldiaminodiphenylmethane, N,N-dimethyl-p-phenylene-diamine, 1,2-dianilinoethylene, p,p',p"-hexamethyltriaminotriphenylmethane, p,p'-tetramethyldiaminotriphenylmethane, p,p'-tetramethyldiaminodiphenylmethylimine, p,p',p"-triamino-o-methyltriphenylmethane, p,p',p"-triaminotriphenylcarbinol, p,p'-tetramethylaminodiphenyl-4-anilinonaphthylmethane, p,p',p"-triaminotriphenylmethane, p,p',p"-hexapropyltriaminotriphenylmethane, etc.

As the color-changing agents which initially possess their intrinsic colors and, as a result of mutual action with a photolysis product of the o-quinonediazide compound, change in color or become decolored, there are effectively used various dyes such as diphenylmethane or triphenylmethane series dyes, thiazine series dyes, oxazine series dyes, xanthene series dyes, anthraquinone series dyes,

iminonaphthoquinone series dyes, azomethine series dyes, etc.

Examples thereof include: Brilliant Green, Eosine, Ethyl Violet, Erythrosine, Methyl Green, Crystal Violet, Basic Fuchsine, phenolphthalein, 1,3-diphenyltriazine, Alizarine Red, Thymolphthalein, Methyl Violet 2B, Quinaldine Red, Rose Bengale, Metanil Yellow, Thymolsulfophthalein, Xylenol Blue, Methyl Orange, Orange IV, diphenylthiocarbazone, 2,7-dichlorofluorescein, Paramethyl Red, Congo Red, Benzopurpurin 4B, α-Naphthyl Red, Nile Blue 2B, Nile Blue A, phenacetolin, Methyl Violet, Malachite Green, Parafuchsine, Oil Blue #603 (product of Orient Kagaku Kogyo Kabushiki Kaisha), Oil Pink #312 (product of Orient Kagaku Kogyo Kabushiki Kaisha), Oil Scarlet #308 (product of Orient Kagaku Kogyo Kabushiki Kaisha), Oil Red OG (product of Orient Kagaku Kogyo Kabushiki Kaisha), Oil Red RR (product of Orient Kagaku Kogyo Kabushiki Kaisha), Oil Green #502 (product of Orient Kagaku Kogyo Kabushiki Kaisha), Spilon Red BEH Special (product of Hodogaya Chemical Co., Ltd.), m-Cresol Purple, Cresol Red, Rhodamine B, Rhodamine 6G, Fast Acid Violet R, Sulforhodamine B, Auramine, 4-p-diethylaminophenyliminonaphthoquinone, 2-carboxyanilino-4-p-diethylaminophenyliminonaphthoquinone, 2-carbostearylamino-4-p-dihydroxyethylaminophenylimino-

naphthoquinone, p-methoxybenzoyl-p'-diethylamino-o'-methylphenyliminoacetanilide, cyano-p-diethylaminophenyliminoacetanilide, 1-phenyl-3-methyl-4-p-diethylaminophenylimino-5-pyrazolone, and 1-β-naphthyl-4-p-diethylaminophenylimino-5-pyrazolone.

The ratio of the above-described color-changing agent to the compound represented by the foregoing general formula (I) is such that about 0.01 part by weight to about 100 parts by weight, preferably 1 to 50 parts by weight, of the compound represented by the general formula (I) is used per part by weight of the color-changing agent.

Known free radical-producing agents may be incorporated in the composition of the present invention. As the specific examples of such known agents, there are illustrated trihalomethyl compounds described in U.S. Patents 4,160,671 and 4,232,106.

On the other hand, the light-sensitive, resist-forming composition to be provided with the print-out ability by the print-out composition of the present invention includes, as has been described hereinafter, various ones for preparing various printing plates such as lithographic printing plates, IC circuits, photomasks, etc. Typical examples thereof are described below.

(1) Compositions comprising diazo resins:

Diazo resins represented by a condensate between p-diazodiphenylamine and paraformaldehyde may be water-soluble or water-insoluble but, preferably, those which are water-insoluble and soluble in ordinary organic solvents are used. Particularly preferable diazo compounds include salts of a condensate between p-diazophenylamine and formaldehyde or acetaldehyde, such as phenol salts, fluorocapric acid salts, and salts of sulfonic acids (e.g., triisopropylnaphthalenesulfonic acid, 4,4-biphenyldisulfonic acid, 5-nitro-o-toluenesulfonic acid, 5-sulfosalicylic acid, 2,5-dimethylbenzenesulfonic acid, 2-nitrobenzenesulfonic acid, 3-chlorobenzenesulfonic acid, 3-bromobenzenesulfonic acid, 2-chloro-5-nitrobenzenesulfonic acid, 2-fluorocaprylnaphthalenesulfonic acid, 1-naphthol-5-sulfonic acid, 2-methoxy-4-hydroxy-5-benzoylbenzenesulfonic acid, p-toluenesulfonic acid, etc.). In addition, diazoresin tetrafluoroborate and hexafluorophosphate are also preferable. Other desirable diazo resin includes a condensate between 2,5-dimethoxy-4-p-tolylmercaptobenzenediazonium and formaldehyde and a condensate between 2,5-dimethoxy-4-morpholinobenzenediazonium and formaldehyde or acetaldehyde, including the above-described salts.

Further, the diazo resin described in B.P. 1,312,925 is also preferable.

Diazo resins can be used solely as light-sensitive materials for use in forming resists but, preferably, they are used in combination with a binder.

As such binder, various high molecular compounds can be used, with those having the group of hydroxy, amino, carboxylic acid, amido, sulfonamido, active methylene, thioalcohol, epoxy, etc. being preferable. Preferable binders include shellac described in B.P. 1,350,521, polymers containing as main repeating units hydroxyethyl acrylate or hydroxyethyl methacrylate units as described in B.P. 1,460,978 and U.S. Patent 4,123,276, polyamide resin described in U.S. Patent 3,751,257, phenol resin described in B.P. 1,074,392 and polyvinyl acetal resins such as polyvinyl formal resin and polyvinyl butyral resin, linear polyurethane resin described in U.S. Patent 3,660,097, polyvinyl alcohol phthaloylated resin, epoxy resin prepared from bisphenol A and epichlorohydrin, amino group-containing polymers such as polyaminostyrene and polyalkylamino(meth)acrylate, cellulose such as cellulose acetate, cellulose alkyl ether, cellulose acetate phthalate, etc. In addition, p-hydroxyphenylmethacrylamide copolymer described in Japanese Patent Application (OPI) No. 98614/79 and methyl methacrylate/acrylonitrile/

methacrylic acid copolymer described in Japanese Patent Application (OPI) No. 4144/81 are also preferable.

The content of the binder is suitably 40 to 95 wt% of the light-sensitive, resist-forming composition. As the content of the binder increases (or as the content of the diazo resin decreases), there naturally results an increased light sensitivity, with storage stability being deteriorated. The optimal content of the binder is about 70 to 90 wt%.

To the diazo resin-containing composition may be added those additives which are described in U.S. Patent 3,236,646 such as phosphoric acid, dyes and pigments not changing their colors.

(2) Compositions comprising o-quinonediazide compounds:

Particularly preferable o-quinonediazide compounds are naphthoquinonediazide compounds which are described in many publications including U.S. Patents 2,766,118, 2,767,092, 2,772,972, 2,859,112, 2,907,665, 3,046,110, 3,046,111, 3,046,115, 3,046,118, 3,046,119, 3,046,120, 3,046,121, 3,046,122, 3,046,123, 3,061,430, 3,102,809, 3,106,465, 3,635,709, 3,647,443, etc. Of these, o-naphthoquinonediazide-sulfonic acid esters or o-naphthoquinonediazide-carboxylic acid esters of aromatic hydroxy compounds, and o-naphthoquinonediazide-sulfonic acid amide or o-naphthoquinonediazide-carboxylic acid amides of aromatic amino compounds are preferable. In particular, an esterification reaction product of o-naphthoquinonediazide-sulfonic acid with a pyrogallol-acetone condensate described in U.S. Patent 3,635,709, an esterification reaction product of o-naphthoquinonediazide-sulfonic acid or o-naphthoquinonediazide-carboxylic acid with polyester having terminal hydroxy groups described in U.S. Patent 4,028,111, an esterification reaction product of o-naphthoquinonediazide-sulfonic acid or o-naphthoquinonediazide-carboxylic acid with a p-hydroxystyrene homopolymer or a copolymer of p-hydroxystyrene and other copolymerizable monomer as described in B.P. 1,494,043, and an amidation reaction product of o-naphthoquinonediazide-sulfonic acid or o-naphthoquinonediazide-carboxylic acid with a copolymer of p-aminostyrene and other copolymerizable monomer are extremely excellent.

These o-quinonediazide compounds may be used independently but, preferably, they are used in combination with an alkali-soluble resin. Preferable alkali-soluble resin includes novolak type phenol resins, specifically, phenol-formaldehyde resin, o-cresol-formaldehyde resin, m-cresol-formaldehyde resin, etc. Further, combined use of a condensate of phenol or cresol substituted by an

alkyl group containing 3 to 8 carbon atoms and formaldehyde, such as t-butylphenol-formaldehyde resin and the above-described phenol resin is more preferable as described in Japanese Patent Application (OPI) No. 125806/75 corresponding to U.S. Patent 4,123,279. The alkali-soluble resin is incorporated in a content of about 50 to about 85 wt%, preferably 60 to 80 wt%, based on the total weight of the light-sensitive, resist-forming composition.

The light-sensitive composition comprising the o-quinonediazide compound may contain, if necessary, pigments or dyes not functioning as color-changing agents, plasticizers, etc.

In incorporating the aforesaid print-out composition in the above-described light-sensitive, resist-forming composition, the print-out composition can be incorporated in an amount of about 0.1 part by weight to about 150 parts by weight, preferably 1 to 60 parts by weight, in 100 parts by weight of the light-sensitive, resist-forming composition.

As solvents to be used for coating the light-sensitive, resist-forming composition provided with the print-out ability, there are illustrated ethylene dichloride, cyclohexanone, methyl ethyl ketone, 2-methoxyethyl acetate, monochlorobenzene, toluene,

ethyl acetate, etc., which may be used alone or in combination of two or more of them.

The light-sensitive, resist-forming composition with print-out ability is particularly advantageously used as a light-sensitive layer of a light-sensitive lithographic plate for preparing a lithographic printing plate. In this case, metal plates such as aluminum (including aluminum alloy), zinc, iron, copper, etc. and plastics having laminated or deposited thereon these metals are used as supports, with aluminum plates being the most preferable. With supports having metal surface, particularly aluminum surface, they are preferably subjected to such surface treatment as graining treatment, dipping treatment in an aqueous solution of sodium silicate, potassium fluorozirconate or phosphate, or anodizing treatment. In addition, an aluminum plate having been dipped in an sodium silicate aqueous solution after being grained as described in U.S. Patent 2,714,066 and an aluminum plate having been dipped in an aqueous solution of alkali metal silicate after being anodized as described in U.S. Patent 3,181,461 are also preferable. The above-described anodizing treatment is effected by conducting a current into an aqueous solution or non-aqueous solution of inorganic acids such as phosphoric acid, chromic acid, sulfuric

acid, boric acid, etc. or organic acids such as oxalic acid, sulfamic acid, etc. or the salts thereof, alone or in combination of two or more, particularly an aqueous solution of phosphoric acid, sulfuric acid or the mixture thereof, using the aluminum plate as the anode. Also, electrodeposition of silicate as described in U.S. Patent 3,658,662 is effected. Further, an aluminum plate which has been electrolyzed in a hydrochloric acid electrolytic solution by using AC and then anodized in a sulfuric acid electrolytic solution as described in B.P. 1,208,224 is also preferable. To provide a subbing layer of cellulose resin containing a water soluble salt of a metal such as zinc on the thus anodized aluminum plate is preferable for preventing scumming upon printing.

The light-sensitive layer is coated on the support in an amount of about 0.1 to about 7 $g/m^2$, preferably 0.5 to 4 $g/m^2$.

The thus obtained PS plates are imagewise exposed and subjected to processings including development processing in a conventional manner to form images. For example, when processed with developing solutions described in, e.g., U.S. Patents 3,669,660, 3,751,257, 4,186,006, B.P. 1,515,174, 2,068,136, West German OLS 2,809,774, Japanese Patent Application (OPI)

No. 77401/76, 90602/76, 86328/79, 52054/80, etc., after imagewise exposing PS plates having a light-sensitive layer of a light-sensitive composition prepared by incorporating the print-out composition in the aforesaid composition (1) comprising diazo resins which undergo removal of unexposed areas of the light-sensitive layer to provide lithographic printing plates. With PS plates having a light-sensitive layer of a light-sensitive composition prepared by incorporating the print-out composition in the aforesaid composition (2), lithographic printing plates can be obtained by imagewise exposing the PS plates and removing exposed areas through development with an alkaline aqueous solution such as an alkali metal silicate aqueous solution described in U.S. Patent 4,259,434 and International Patent Application WO 82/01086. With PS plates having any light-sensitive layer, no special techniques for development are required in the present invention of imparting print-out ability, and conventionally known developing solutions suitable for particular light-sensitive compositions can be employed.

The light-sensitive, resist-forming composition provided with the print-out ability can be used for making proofing plates, films for overhead projectors, and films for second originals. As supports

suited for such uses, there are illustrated transparent films such as polyethylene terephthalate film, cellulose triacetate film, etc. and chemically or physically surface-matted films thereof.

In addition, the aforesaid composition can be used for making photomask films. As supports suited for this use, there are illustrated polyethylene terephthalate film having deposited thereon aluminum, aluminum alloy or chromium and polyethylene terephthalate films having provided thereon a colored layer.

Further, the aforesaid composition can be used as photoresist. In this case, copper plates or copper-plated plates, stainless steel plates, glass plates, etc. can be used as supports.

It is quite surprizing that the free radical-producing agents of the present invention decompose when struck by light in a light-sensitive, resist-forming composition containing various light-sensitive, resist-forming compounds and effectively and immediately change the color of a copresent color-changing agent. As a result, a distinct boundary is formed between exposed areas and unexposed areas, thus a highly contrasty image becomes visible.

Since a wide scope of color-changing agents can be used, desired color-changing agents can be

selected even when various additives are added for improving properties of a light-sensitive composition.

The present invention will now be described in more detail by the following Synthesis Examples and Examples which, however, are not to be construed as limiting the present invention in any way.

Synthesis Example 1

Synthesis of o-(1,2-naphthoquinone-2-diazido-4-sulfonyl)-N-acetyl-N-methylhydroxylamine (illustrative compound No. 1):

100 mℓ of methanol was added to 15.0 g of N-methylhydroxylamine hydrochloride and, while cooling to 10°C or lower, 19.1 g of sodium carbonate was gradually added thereto. To this reaction solution was dropwise added 14.1 g of acetyl chloride in 30 minutes, and the reaction was continued for 30 minutes at 10°C or lower then for one hour at room temperature. The precipitate formed was removed by filtration, and methanol was removed under reduced pressure, followed by distillation under reduced pressure to obtain 7.3 g of N-acetyl-N-methylhydroxylamine. b.p. 76 - 81°C/2 mmHg.

100 mℓ of dioxane was added to 3.6 g of N-acetyl-N-methylhydroxylamine and 10.7 g of 1,2-naphthoquinone-2-diazido-4-sulfonyl chloride and, under

stirring, a solution of 4.1 g of triethylamine in 20 mℓ of dioxane was dropwise added thereto in 2 hours with cooling so that the temperature of the reaction solution did not exceed 25°C. After further conducting the reaction at 15 to 25°C for 2 hours, the reaction solution was thrown into 300 mℓ of water, and the precipitate formed was collected by filtration. Recrystallization of the precipitate from an ethanol/acetonitrile mixture solvent yielded 8.1 g of o-(1,2-naphthoquinone-2-diazido-4-sulfonyl)-N-acetyl-N-methylhydroxylamine. m.p. 151-153°C (d.)

Synthesis Example 2

Synthesis of o-(1.2-naphthoquinone-2-diazido-4-sulfonyl)-N-lauroyl-N-methylhydroxylamine (illustrative compound No. 3):

100 mℓ of tetrahydrofuran was added to 10.0 g of N-methylhydroxylamine hydrochloride, and 19.0 g of pyridine was further added; thereto. Then, a solution of 26.2 g of lauryl chloride in 100 mℓ of tetrahydrofuran was dropwise added thereto in one hour at room temperature under stirring. The reaction was further continued for 8 hours at room temperature. After adding thereto 50 mℓ of dilute hydrochloric acid, tetrahydrofuran was removed therefrom under reduced pressure. The residue was extracted with ethyl acetate, then ethyl acetate

was removed under reduced pressure to obtain a crude product. Recrystallization of the crude product from hexane yielded 10.6 g of N-lauroyl-N-methylhydroxylamine (m.p. 48 - 49°C).

100 mℓ of tetrahydrofuran was added to 9.2 g of N-lauroyl-N-methylhydroxylamine and 10.7 g of 1,2-naphthoquinone-2-diazido-4-sulfonyl chloride and, under stirring, a solution of 4.1 g of triethylamine in 20 mℓ of tetrahydrofuran was dropwise added thereto in 2 hours with cooling so that the temperature of the reaction solution did not exceed 25°C. After continuing the reaction for another two hours at 15 to 25°C, the reaction solution was added to 500 mℓ of water, followed by collecting the precipitate by filtration. Recrystallization of the precipitate from ethanol yielded 12.4 g of o-(1,2-naphthoquinone-2-diazido-4-sulfonyl)-N-lauroyl-N-methylhydroxylamine having a melting point of 104 - 108°C (d.).

Synthesis Example 3

Synthesis of o-(1,2-naphthoquinone-2-diazido-4-sulfonyl)-N-benzoyl-N-methylhydroxylamine (illustrative compound No. 6):

10.0 g of N-methylhydroxylamine hydrochloride was thrown into 100 mℓ of tetrahydrofuran, and 19.8 g of pyridine was added thereto. A solution of 16.8 g

of benzoyl chloride in 100 mℓ of tetrahydrofuran was dropwise added to the resulting mixture at room temperature under stirring. The stirring was continued for 8 hours for the reaction to proceed. After adding thereto 50 mℓ of dilute hydrochloric acid, tetrahydrofuran was removed therefrom under reduced pressure, followed by extraction with ethyl acetate. The extract was dehydrated with anhydrous magnesium sulfate, and ethyl acetate was removed under reduced pressure. The thus obtained crude product was purified through column chromatograph (filler: silica gel; developing solution: ethyl acetate/hexane) to obtain 8.5 g of N-benzoyl-N-methylhydroxylamine (an oil with a m.p. of not higher than 20°C). 130 mℓ of tetrahydrofuran was added to 7.6 g of N-benzoyl-N-methylhydroxylamine and 13.4 g of 1,2-naphthoquinone-2-diazido-4-sulfonyl chloride, and a solution of 5.1 g of triethylamine in 20 mℓ of tetrahydrofuran was dropwise added thereto in 2 hours with cooling so that the temperature of the reaction solution did not exceed 25°C. After continuing the reaction at 15 to 25°C for 2 hours, the reaction solution was thrown into 700 mℓ of water to collect the precipitate formed. Recrystallization of the precipitate from acetonitrile yielded 11.5 g of o-(1,2-naphthoquinone-2-diazido-4-sulfonyl)-N-benzoyl-N-methylhydroxylamine. m.p. 154-157°C (d.).

Synthesis Example 4

Synthesis of o-(1,2-naphthoquinone-2-diazido-4-sulfonyl)-N-(p-chlorophenyl)-N-methylhydroxylamine (illustrative compound No. 7):

11.9 g of N-methylhydroxylamine hydrochloride was added to 100 mℓ of pyridine and, under cooling to not higher than 10°C, 25.0 g of p-chlorobenzoyl chloride was dropwise added thereto in one hour. After conducting the reaction for 2 hours at not higher than 10°C, then for 2 hours at room temperature, the reaction solution was added to 1000 mℓ of water. After neutralization of the solution with conc. hydrochloric acid, it was extracted with 200 mℓ of ethyl acetate. The extract was dried with anhydrous magnesium sulfate, then the solvent was removed under reduced pressure. The residue was washed with n-hexane. Recrystallization of the residue from toluene/n-hexane mixture yielded 9.2 g of N-(p-chlorobenzoyl)-N-methylhydroxylamine (m.p. 116 - 118°C).

80 mℓ of tetrahydrofuran was added to 3.7 g of N-(p-chlorobenzoyl)-N-methyhydroxylamine and 5.4 g of 1,2-naphthoquinone-2-diazido-4-sulfonyl chloride, and a solution of 2.0 g of triethylamine in 20 mℓ of tetrahydrofuran was added dropwise thereto in 2 hours with cooling so that the temperature of the reaction

solution did not exceed 25°C. After continuing the reaction at 15 to 25°C for 2 hours, the reaction solution was thrown into 500 mℓ of water to collect the formed precipitate by filtration. Recrystallization of the precipitate from an ethanol/acetonitrile mixture solvent yielded 4.2 g of o-(1,2-naphthoquinone-2-diazido-4-sulfonyl)-N-(p-chlorobenzoyl)-N-methylhydroxylamine. m.p. 156 - 158°C.

Synthesis Example 5

Synthesis of o-(1,2-naphthoquinone-2-diazido-4-sulfonyl)-N-benzoyl-N-phenylhydroxylamine (illustrative compound No. 14):

100 mℓ of tetrahydrofuran was added to 10.7 g of N-benzoyl-N-phenylhydroxylamine and 13.4 g of 1,2-naphthoquinone-2-diazido-4-sulfonyl chloride, and a solution of 5.1 g of triethylamine in 20 mℓ of tetrahydrofuran was dropwise added thereto in 2 hours with cooling the solution so that the temperature of the reaction solution did not exceed 25°C. After continuing the reaction at 15 to 25°C for 2 hours, the reaction solution was thrown into 500 mℓ of water to collect formed precipitate by filtration. Recrystallization of the precipitate from 50 mℓ of N,N-dimethylformamide and 200 mℓ of acetonitrile gave 14.1 g of o-(1,2-naphthoquinone-2-diazido-4-sulfonyl)-N-benzoyl-N-phenylhydroxylamine. m.p. 162 - 165°C.

Example 1

The following light-sensitive solution was coated on 0.15-mm thick, surface-grained aluminum plate using a whirler, then dried at 80°C for 5 minutes to prepare light-sensitive plates.

| | |
|---|---|
| Cresol novolak resin | 10.5 g |
| o-Naphthoquinonediazide compound given in Table 1 | 3.0 g |
| Crystal Violet | 0.1 g |
| Tetrahydrofuran | 70 mℓ |
| Methyl cellosolve | 15 mℓ |
| N,N-Dimethylformamide | 35 mℓ |

The dry amount of the coated light-sensitive layer was 1.5 $g/m^2$.

Each of these light-sensitive plates was exposed for 15 counts using a jet printer (2 kW superhigh pressure mercury lamp; made by ORC Manufacturing Company), and optical densities of exposed areas and unexposed areas were measured using a reflection densitometer.

Optical densities of exposed and unexposed areas and optical density differences (ΔD) therebetween are tabulated in Table 1. The higher the difference (ΔD), the more distinct the image.

Table 1

Properties of visible images after exposure of light-sensitive plates

| Run No. | o-Naphthoquinone Compound | Optical Density: Unexposed Areas | Optical Density: Exposed Areas | ΔD |
|---|---|---|---|---|
| 1 | Illustrative Compound No. 1 | 0.99 | 0.76 | 0.23 |
| 2 | Illustrative Compound No. 7 | 1.00 | 0.78 | 0.22 |
| (Comparative Example 1) | 1,2-Naphthoquinone-2-diazido-4-sulfonyl chloride | 0.77 | 0.53 | 0.24 |
| (Comparative Example 2) | 1,2-Naphthoquinone-2-diazido-4-sulfonic acid p-dimethylphenyl-methylphenyl ester | 0.96 | 0.91 | 0.05 |
| (Comparative Example 3) | 1,2-Naphthoquinone-2-diazido-4-sulfonic acid p-tert-butyl-phenyl ester | 1.00 | 0.95 | 0.05 |
| (Comparative Example 4) | N-(1,2-Naphthoquinone-2-diazido-4-sulfonyl) morpholine | 0.98 | 0.97 | 0.01 |
| (Comparative Example 5) | 1,2-Naphthoquinone-2-diazido-4-sulfonic acid phenyl ester | 0.98 | 0.91 | 0.07 |

As is shown in Table 1, sulfonic esters or sulfonamides given as (Comparative Example 2) to (Comparative Example 5) provided less differences in optical density between exposed areas and unexposed areas. On the other hand, 1,2-naphthoquinone-2-diazido-4-sulfonyl chloride, given as (Comparative

Example 1), has the defect that it decreases optical density in unexposed areas, though it provides large ΔD. In comparison with these, the o-naphthoquinonediazide compound of the present invention provided enough large ΔD without decreasing the optical density of unexposed areas, thus the objects of the present invention being attained.

Then, a step wedge (step difference in density: 0.15; density step number: 1 to 15) was placed on each of the light-sensitive plates prepared in this Example and exposed for 15 counts using the aforesaid jet printer. Subsequently, they were developed for 60 seconds at 25°C in a 15-time diluted solution of DP-3 (trade name of developing solution for positive working PS plates; product of Fuji Photo Film Co., Ltd.) to measure sensitivity. The step number of the step wedge corresponding to the appearing image of each sample is given in Table 2. Higher step number means higher sensitivity.

Table 2

| Run No. | o-Naphthoquinone Compound | Step Number of Step Wedge After Development |
|---|---|---|
| 1 | Illustrative Compound No. 1 | 4 |
| 2 | Illustrative Compound No. 7 | 4 |
| (Comparative Example 1) | 1,2-Naphthoquinone-2-diazido-4-sulfonyl chloride | 2 |
| (Comparative Example 2) | 1,2-Naphthoquinone-2-diazido-4-sulfonic acid p-dimethylphenylmethylphenyl ester | 3.5 |
| (Comparative Example 3) | 1,2-Naphthoquinone-2-diazido-4-sulfonic acid p-tert-butylphenyl ester | 3 |
| (Comparative Example 4) | N-(1,2-Naphthoquinone-2-diazido-4-sulfonyl)morpholine | 5 |
| (Comparative Example 5) | 1,2-Naphthoquinone-2-diazido-4-sulfonic acid phenyl ester | 2.5 |

As is shown in Table 2, the o-naphthoquinonediazide compound of (Comparative Example 4) provided only small ΔD as shown in Table 1, though it showed high sensitivity. The o-naphthoquinonediazide compound of (Comparative Example 1) provided low sensitivity, though it provided large ΔD as shown in Table 1.

On the other hand, the o-naphthoquinone compounds of the present invention provided large ΔD and sufficiently high sensitivity.

## Example 2

The following light-sensitive solution was coated on an aluminum plate having been processed in the same manner as in example 1 using a whirler, then dried at 100°C for 2 minutes to prepare light-sensitive plates.

| | |
|---|---|
| A condensate between 1,2-naphthoquinone-2-diazido-5-sulfonyl chloride and m-cresol-formaldehyde novolak resin (condensation ratio: 33 mol %) | 0.60 g |
| o-Naphthoquinonediazide compound given in Table 3 | 0.14 g |
| Cresol novolak resin | 2.0 g |
| Tetrahydrophthalic anhydride | 0.15 g |
| Crystal Violet | 0.02 g |
| Ethylene dichloride | 18 g |
| Methyl cellosolve | 12 g |

The dry amount of the coated light-sensitive layer was 1.8 $g/m^2$.

Each of these light-sensitive plates was exposed using a 30-A carbon arc lamp spaced at a distance of 70 cm, then developed at 25°C for 30 seconds with a 6-time diluted solution of DP-3 (trade name of developing solution for positive working PS plates; product of Fuji Photo Film Co., Ltd.) to measure sensitivity. The sensitivity was evaluated using a

step wedge (step difference in density: 0.15; density step number: 0 to 15). Higher step number means higher sensitivity.

In addition, optical densities of exposed and unexposed areas of the light-sensitive layers of the plates after only exposure were measured using a Macbeth densitometer.

Further, unexposed light-sensitive plates were left under natural conditions for 2 months, then exposed and subjected to the same measurement as described above.

With the images obtained by exposure, the higher the density difference ($\Delta D$) between exposed areas and unexposed areas, the more distinct the image.

Table 3

| Run No. | o-Naphthoquinonediazide compound | Step Number of Step Wedge (Resist Sensitivity) | Optical Density of Light-sensitive layer: One day after coating *1 | *2 | ΔD | After 2 months under natural conditions *1 | *2 | ΔD |
|---|---|---|---|---|---|---|---|---|
| 1(*) | Illustrative compound No. 6 | 3.8 | 0.88 | 0.76 | 0.12 | 0.88 | 0.76 | 0.12 |
| 2(**) | no | 3.8 | 0.88 | 0.88 | 0.00 | 0.88 | 0.88 | 0.00 |
| 3(**) | 1,2-Naphthoquinone-2-diazido-4-sulfonic acid phenyl ester | 3.8 | 0.88 | 0.80 | 0.08 | 0.87 | 0.82 | 0.05 |
| 4(**) | 1,2-Naphthoquinone-2-diazido-4-sulfonic acid 2,4-dinitrophenyl ester | 3.5 | 0.86 | 0.78 | 0.08 | 0.85 | 0.81 | 0.04 |

(*): present invention
(**): comparative example
*1: unexposed area
*2: exposed area

As is shown in Table 3, 2,4-dinitrophenyl 1,2-naphthoquinone-2-diazido-4-sulfonate provided only insufficient ΔD and decreased optical density in unexposed areas and resist sensitivity. On the other hand, the o-naphthoquinonediazide compounds in accordance with

the present invention provided large ΔD, showed excellent stability with time, and did not adversely affect resist sensitivity, thus the intended objects being fully attained.

Example 3

The following light-sensitive solution was coated on a 0.24-mm thick aluminum plate having been surface-grained and anodized, then dried at 100°C for 2 minutes.

| | |
|---|---|
| Esterification reaction product between naphthoquinone-(1,2)-diazido-(2)-5-sulfonyl chloride and cresol novolak resin | 0.75 g |
| Cresol novolak resin | 2.10 g |
| Tetrahydrophthalic anhydride | 0.15 g |
| Illustrative compound No. 1 | 0.10 g |
| Crystal Violet | 0.01 g |
| Oil Blue #603 (product of Orient Kagaku Kogyo K.K.) | 0.01 g |
| Ethylene dichloride | 18 g |
| Methyl cellosolve acetate | 12 g |

The dry amount of coated solution was 2.2 $g/m^2$.

When this light-sensitive lithographic plate was imagewise exposed, a distinct print-out image was obtained without development. In the print-out image, exposed areas were faded and unexposed areas

kept initial density, thus the image being recognized in detail under safe light.

Example 4

The following light-sensitive solution was coated on the same aluminum plate as obtained in Example 3 to prepare a light-sensitive lithographic plate.

| | |
|---|---|
| Esterification product between naphthoquinone-(1,2)-diazido-(2)-5-sulfonyl chloride and poly-p-hydroxystyrene (molecular weight: 7000) | 0.70 g |
| Cresol novolak resin | 2.25 g |
| p-tert-Butylphenol novolak resin | 0.05 g |
| Tetrahydrophthalic anhydride | 0.15 g |
| Illustrative compound No. 7 | 0.10 g |
| Oil Blue #603 | 0.02 g |
| Tetrahydrofuran | 18 g |
| Methyl cellosolve acetate | 12 g |

When this plate was imagewise exposed, a distinct print-out image was obtained without development.

Example 5

The following light-sensitive solution was coated on the same aluminum plate as obtained in Example 3 to prepare a lithographic plate.

| | |
|---|---|
| Esterification product between 1,2-naphthoquinone-2-diazido-5-sulfonyl chloride and pyrogallol/acetone resin (described in Example 1 of U.S. Patent 3,635,709) | 0.80 g |
| Illustrative compound No. 6 | 0.10 g |
| Cresol-formaldehyde resin | 1.7 g |
| Oil-soluble dye (C.I. 42595) | 0.03 g |
| Phthalic anhydride | 0.20 g |
| 2-(p-Butoxyphenyl)-4,6-bis-(trichloromethyl)-s-triazine | 0.02 g |
| Ethylene dichloride | 15 g |
| Ethyl cellosolve | 8 g |

When this plate was imagewise exposed, a distinct print-out image was obtained without development.

While the invention has been described in detail and with reference to specific embodiment thereof, it will be apparent to one skilled in the art that various changes and modifications can be made therein without departing from the spirit and scope thereof.

0115156

WHAT IS CLAIMED IS:

1. A light-sensitive composition, comprising:

a o-naphthoquinonediazide compound represented by the general formula (I):

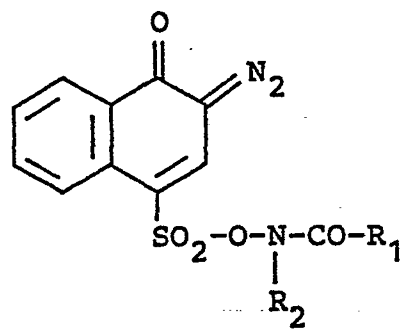

(I)

wherein $R_1$ and $R_2$ independently represent an alkyl group, a substituted alkyl group, an aryl group, a substituted aryl group, a vinyl group or a substituted vinyl group, or $R_1$ and $R_2$ are connected to each other to form an alkylene group; and

a color-changing agent capable of interacting with a photolysis product of the o-naphthoquinonediazide compound and capable of changing color upon the interaction.

2. A light-sensitive composition as claimed in Claim 1, wherein the alkyl group is selected from the group consisting of straight-chain branched-chain and/or cyclic alkyl groups having 1 to 10 carbon atoms, the aryl group includes monocyclic or bicyclic group and the alkylene group formed by a linkage of $R_1$ and $R_2$ has 2 to 10 carbon atoms.

3. A light-sensitive composition as claimed in Claim 1, wherein the substituent of the alkyl group is selected from the group consisting of a halogen atom, an alkoxy gruop having 1 to 2 carbon atoms, an aryl group and an aryloxy group, the substituent of the aryl group is selected from the group consisting of an alkyl group having 1 to 2 carbon atoms, an alkoxy group having 1 to 2 carbon atoms, a halogen atom, a nitoro group, a phenyl group, a carboxy group and a cyano group, and the substituent of the vinyl gruop is selected from the group consisting of an alkyl group having 1 to 5 coarbon atoms, and an aryl group.

4. A light-sensitive composition as claimed in Claim 1, wherein the o-naphthoquinonediazide compound is a compound selected from the group consisting of:

No. 1

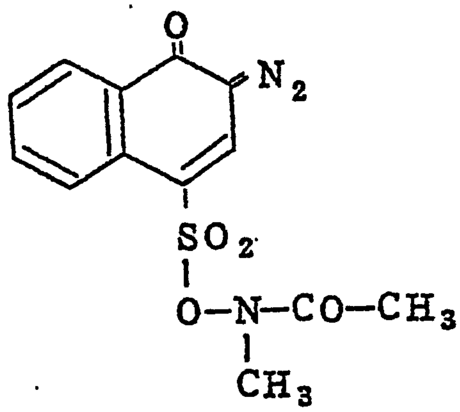

No. 2

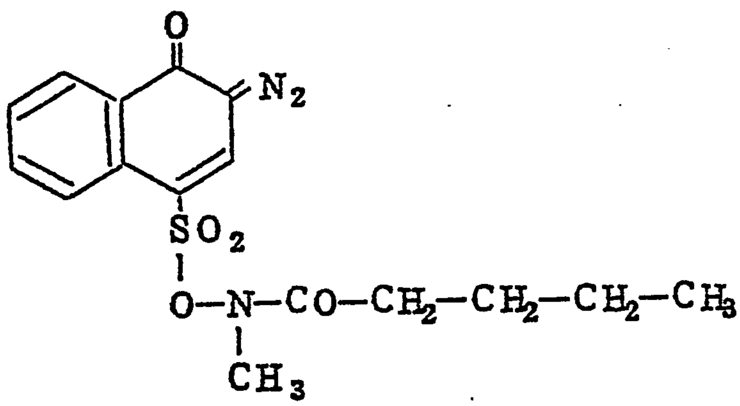

No. 3

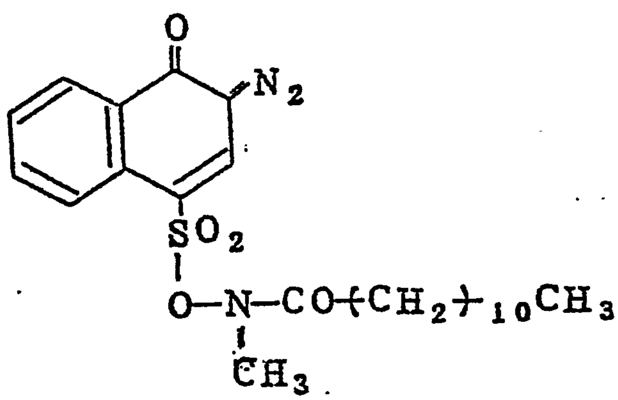

No. 4

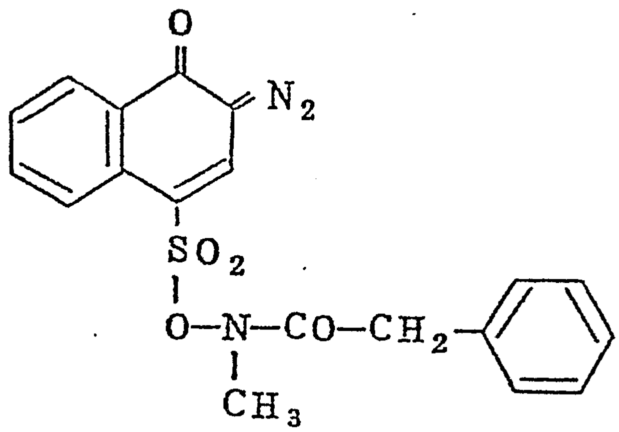

No. 5

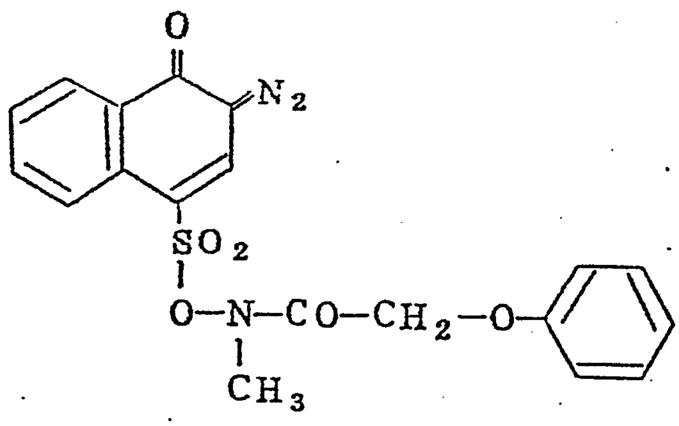

No. 6

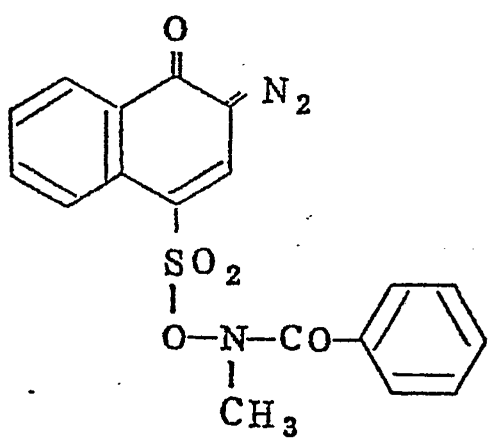

No. 7

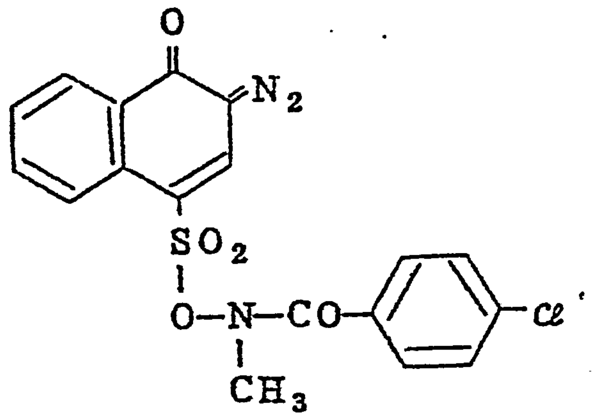

No. 8

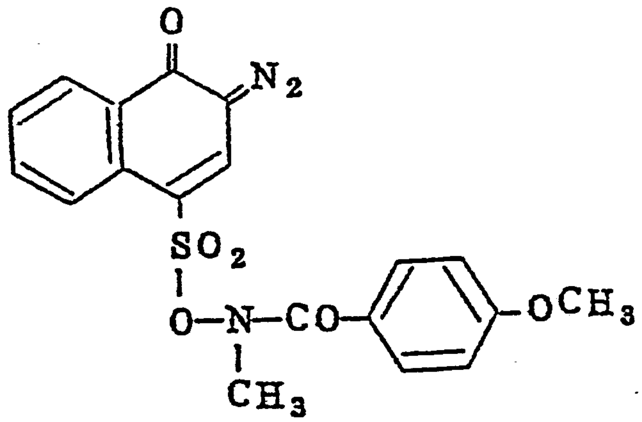

No. 9

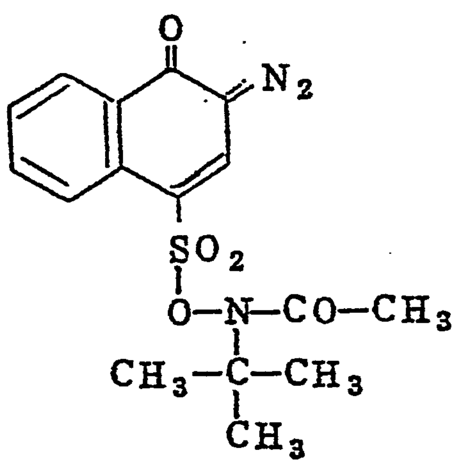

No. 10

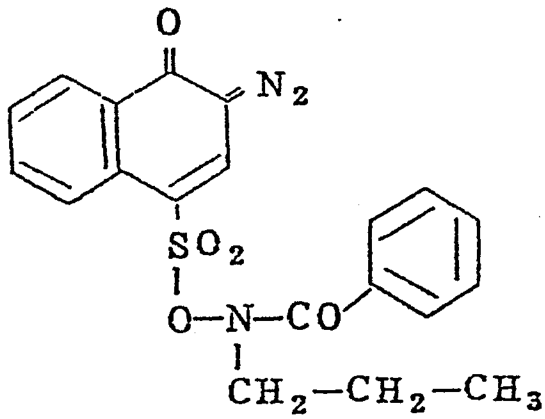

No. 11

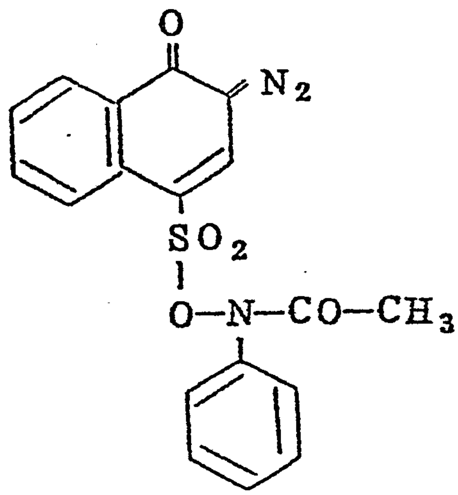

No. 12

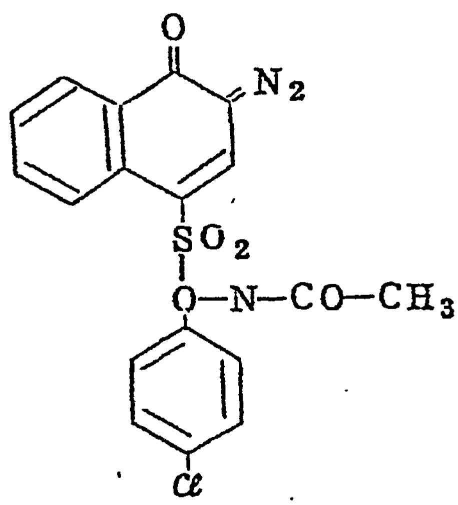

No. 13

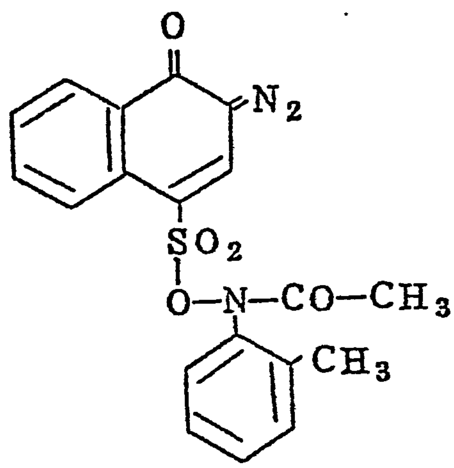

No. 14

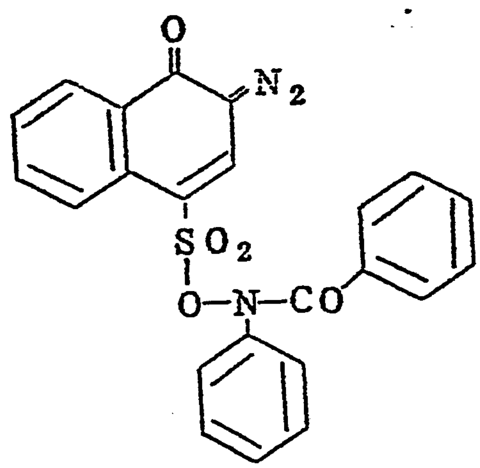

No. 15

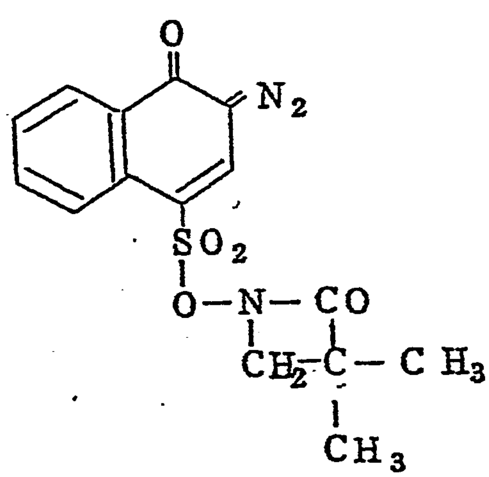

No. 16

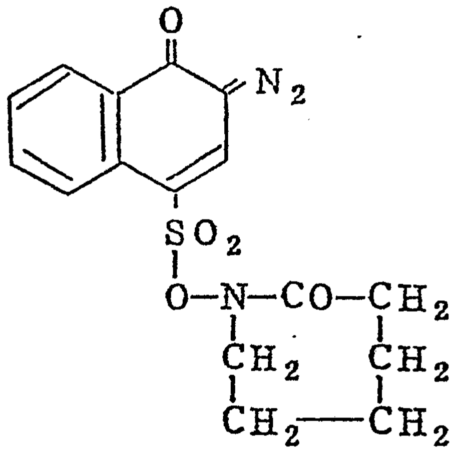

No. 17

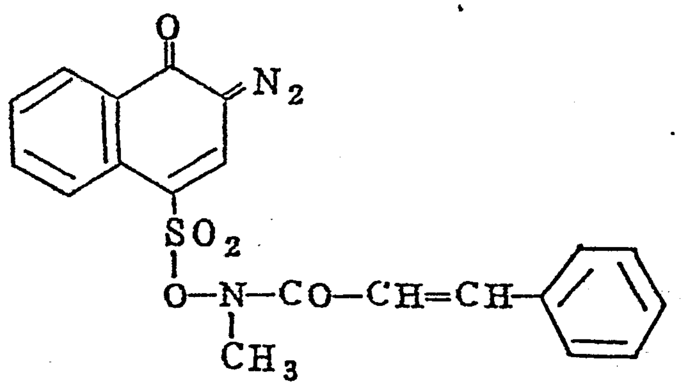

No. 18

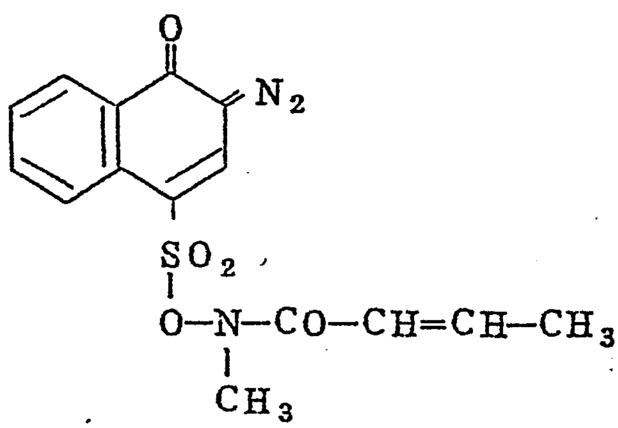

5. A light-sensitive composition as claimed in Claim 1, wherein the color-changing agent is selected from the group consisting of aryl amines.

6. A light-sensitive composition as claimed in Claim 5, wherein the color-changing agent is selected from the group consisting of primary aromatic amines, secondary aromatic amines and leuco dyes.

7. A light-sensitive composition as claimed in Claim 1, wherein the color-changing agent is selected from the group consisting of diphenylmethane series dyes, triphenylmethane series dyes, thiazine series dyes, oxazine series dyes, xanthene series dyes, anthraquinone series dyes, iminonaphthoquinone series dyes, azomethine series dyes.

8. A light-sensitive composition as claimed in Claim 1, wherein the ratio of the color-changing agent to the compound represented by the general formula (I) is about 0.01 parts by weight to about 100 parts by weight.

9. A light-sensitive composition as claimed in Claim 8, wherein the ratio of the color-changing agent to the compound of general formula (I) is in the range of about 1 part by weight to 50 parts by weight.

10. A light-sensitive composition as claimed in

Claim 1, wherein the o-naphthoquinonediazide compound and the color-changing agent are incorporated in a light-sensitive resist-forming composition.

11. A light-sensitive composition as claimed in Claim 10, the light-sensitive resist-forming composition is selected from the group consisting of composition comprising diazo resin, and a composition comprising o-quinonediazide compound.